Europäisches Patentamt

European Patent Office

Office européen des brevets

(11) Publication number: **0 140 350**
**B1**

# EUROPEAN PATENT SPECIFICATION

(45) Date of publication of patent specification: **03.01.90**

(51) Int. Cl.⁵: **G 02 F 1/133**, G 09 F 9/35

(21) Application number: **84112923.2**

(22) Date of filing: **26.10.84**

(54) **Liquid crystal panel display device.**

(30) Priority: **28.10.83 JP 202206/83**

(43) Date of publication of application:
**08.05.85 Bulletin 85/19**

(45) Publication of the grant of the patent:
**03.01.90 Bulletin 90/01**

(84) Designated Contracting States:
**DE FR GB**

(56) References cited:
**GB-A-2 098 374**
**US-A-3 936 816**
**US-A-3 957 351**
**US-A-4 289 383**

(73) Proprietor: **HITACHI, LTD.**
**6, Kanda Surugadai 4-chome Chiyoda-ku**
**Tokyo (JP)**

(72) Inventor: **Masuda, Mitsuhiro**
**Kozanryo 1034, Higashiishikawa-2-chome**
**Katsuta-shi (JP)**
Inventor: **Igarashi, Osamu**
**46-2, Horiguchi**
**Katsuta-shi (JP)**
Inventor: **Tokuyama, Keiichi**
**1292-25, Tarazaki**
**Katsuta-shi (JP)**
Inventor: **Katogi, Kozo**
**Sawaryo, 467 Tabiko**
**Katsuta-shi (JP)**

(74) Representative: **Patentanwälte Beetz sen. -**
**Beetz jun. Timpe - Siegfried - Schmitt-Fumian**
**Steinsdorfstrasse 10**
**D-8000 München 22 (DE)**

Courier Press, Leamington Spa, England.

## Description

The present invention relates to a relatively large transmission type liquid crystal panel display device comprising two or more display blocks which is particularly suited for vehicle instrument panels.

Liquid crystal panels for vehicle instrument panels, particularly for automobile dashboards, are generally of transmission type for easy viewing. Further, since various driving conditions are to be displayed, a large single piece liquid crystal panel has been developed which is divided into a plurality of display blocks for displaying various indications.

Such a liquid crystal instrument panel display device for automobile dashboards is disclosed in JP utility model application 46268/80. The liquid crystal display panel is illuminated from its rear face by means of a lamp and an illumination plate provided laterally. In this case, however, it is difficult to uniformly illuminate the whole surface of the liquid crystal display due to attenuation at the illumination panel and the like. In particular, a large area type liquid crystal panel inevitably involves the problem that the central part of the panel becomes dark.

GB-A-2 098 374 relates to a large size vehicle indication system comprising one or more liquid crystal display blocks illuminated from the backside by means of lamps provided on a common board.

US-A-4 289 383 discloses a dot matrix liquid crystal display which can be operated in the transmissive mode and comprises a liquid crystal panel, a diffusion plate provided on the rear side of the liquid crystal display and a board disposed on the rear side of the diffusion plate and comprising a plurality of equally spaced lamps for illuminating the display from the backside.

However, this type of liquid crystal panel display is not satisfactory in that only the central region can be strongly illuminated, and even if the light is diffused with a diffusion plate, there is still unevenness in brightness. The above direct illumination method may be used, however, for other display purposes except for vehicle panel displays in this case, since there is a sufficient distance from the light source to the display panel, a natural diffusion can be expected. On the other hand, display devices for vehicles should have a reduced thickness, which, in turn, excludes to utilize such a natural diffusion.

It is the object of the present invention to eliminate the prior art disadvantages and to provide a liquid crystal panel display device which can be uniformly illuminated over the whole surface of the liquid crystal panel even if it is relatively large, and to obtain a good recognizability.

The above object is achieved according to claim 1. The dependent claims relate to preferred embodiments.

The liquid crystal panel display device according to the present invention comprises a liquid crystal panel comprising at least two spatially separated display blocks each for displaying another kind of information;

a board disposed opposing the rear face of the liquid crystal panel, and

a plurality of light emitting members disposed in equally spaced relation to each other on the board over the whole region of the liquid crystal panel, and is characterized in that

a diffusion plate is disposed between the rear face of the liquid crystal panel and the light emitting members,

the display device further comprises a frame around each of the display blocks of the liquid crystal panel, the frames having reflecting walls and being disposed between the diffusion plate and the board, and

within each region defined by the frames a plurality of the light emitting members are disposed.

In the following the present invention will be explained with more details with reference to preferred embodiments and in conjunction with the accompanying drawings, in which:

Fig. 1 is a perspective view of a disassembled liquid crystal panel display device according to an embodiment of the present invention;

Fig. 2 is a sectional view of the liquid crystal panel display device shown in Fig. 1, and

Fig. 3 is a perspective view of another embodiment of the liquid crystal panel device according to the present invention.

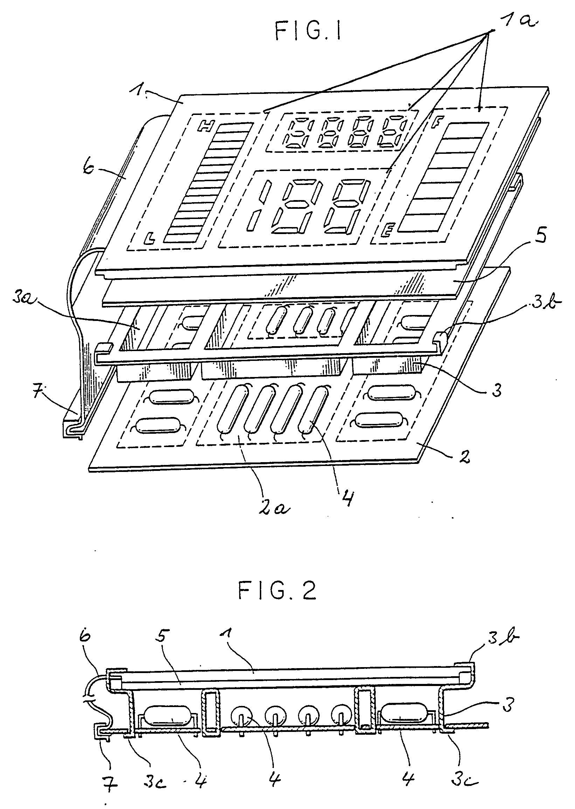

The liquid crystal panel display device shown in Fig. 1 is designed for the instrument panel of automobiles. The liquid crystal panel 1 has a relatively large area and comprises a plurality of display blocks 1a, for example, four in total. The display blocks 1a are provided with respective display portions of, for example, a speedometer, a tachometer, a fuel meter, and a cooling water thermometer. The display portions are separately positioned in the liquid crystal panel 1 as shown in the figure by broken lines. A diffusion plate 5 having generally the same shape and size as the liquid crystal panel 1 is disposed such that it faces the rear side of the liquid crystal panel 1. Further, a drive circuit printed board 2 having generally the same shape and size as the liquid crystal panel 1 is disposed opposing the diffusion plate 5.

The surface of the drive circuit printed board 2 opposing the diffusion plate 5 is provided with incandescent lamps 13 of elongated shape. Each region corresponding to each of the display blocks 1a is provided with, for example, three to four incandescent lamps 13 juxtaposed to each other. Instead of incandescent lamps fluorescent lamps may also be used.

In addition to the above arrangement, a reflecting metal frame 3 is disposed between the drive circuit printed board 2 and the diffusion plate 5. The frame 3 is made of, for example, aluminum or the like which can increase the diffuse reflexion of incident light. The frame 3 is provided with openings corresponding to the respective display blocks 1a. The edge of each of the openings corresponding to the periphery of each display block 1a is provided with a vertical wall 3a perpendicular relative to the drive circuit printed board 2. Further, a part of the edges of the frame 3 abutting upon the drive circuit printed board 2 is provided with a hook 3c. The hook 3c is inserted into and bent at an aperture formed in the drive circuit printed board 2. On the other hand, a part of the corner portions of the frame 3 at the side of the liquid crystal panel 1 is provided with a hook 3b. The hook 3b holds both the liquid crystal panel 1 and the diffusion plate 5.

Further, a flexible connection 6 extends from the liquid crystal panel 1 and is connected to the drive circuit printed board 2 through a metal clamp 7. The surface 2a of the drive circuit printed board 2 partitioned by the frame 3 into respective display blocks 1a is colored white, for example, by silk-screen printing.

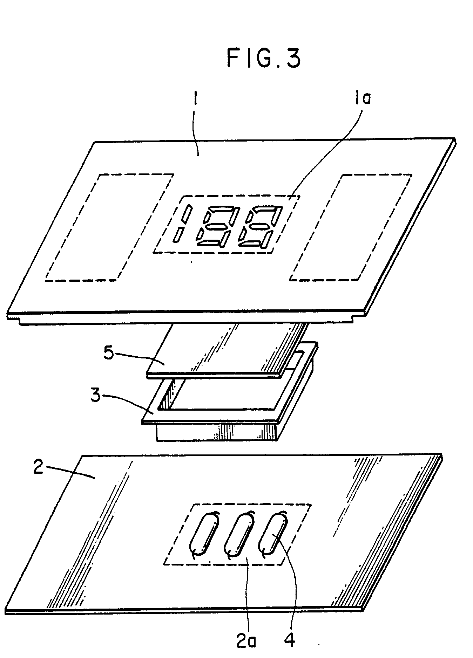

In the liquid crystal panel display device 1 constructed as above and as shown in Fig. 3, a plurality of elongated incandescent lamps 4 are laid side by side on a section 2a of the drive circuit printed board 2, the section 2a being located just below a display block 1a of the liquid crystal panel 1. The same structure is shown in Fig. 1. Since a closed space defined by the drive circuit printed board 2, the liquid crystal panel 1, and the frame 3 which diffusely reflect lights, is provided, the light from the incandescent lamps 4 is repeatedly reflected within this closed space. Therefore, the display block 1a is uniformly illuminated from the transmission medium. Moreover, since a light source is provided independently for each display block 1a, there is no possibility that brightness of each display block 1a varies with the layout of the display blocks 1a within the liquid crystal panel 1. The frame 3 serving as a reflection plate preferably has a rough surface such as of aluminum material because a diffused reflection makes the illuminating light incident on the liquid crystal panel 1 more uniform than an ordinary reflection, thus preventing unevenness or brightness. In case independent illumination for each display block 1a is performed, and each display block 1a has a plurality of light emitting elements 4, it is possible to prevent a breakdown of the whole illumination of a particular display block 1a due to a burn-out of an incandescent lamp 4. The diffusion plate 5 is provided between the display block 1a and the frame 3. A temperature rise in the closed space due to heat generation of the incandescent lamp is not problematic because a moderate heat dissipation can readily be realized if only the reflecting frame 3 is made of a metal such as aluminum. It is noted, however, that such a heat dissipation is not necessary because it is rather preferable to heat the liquid crystal within its working temperature range in view of the improved response characteristic.

It is possible to achieve a thickness of the stack comprising the liquid crystal panel 1, the diffusion plate 5, the frame 3 and the drive circuit printed board 2 within about 15 mm. The whole thickness including a printed circuit board for associated processing circuits, a casing and the like may also be within about 40 mm. Thus, it is possible to obtain a thin display device.

As explained above, the liquid crystal panel display device according to the present invention has the advantage that a uniform illumination over the entire surface of the liquid crystal display is obtained, even if the area of the liquid crystal panel is relatively large.

## Claims

1. A liquid crystal panel display device comprising

a liquid crystal panel (1) comprising at least two spatially separated display blocks (1a) each for displaying another kind of information;

a board (2) disposed opposing the rear face of the liquid crystal panel (1), and

a plurality of light emitting members (4) disposed in equally spaced relation to each other on the board (2) over the whole region of the liquid crystal panel (1), characterized in that

a diffusion plate (5) is disposed between the rear face of the liquid crystal panel (1) and the light emitting members (4),

the display device further comprises a frame (3) around each of the display blocks (1a) of the liquid crystal panel (1), the frames (3) having reflecting walls (3a) and being disposed between the diffusion plate (5) and the board (2), and

within each region defined by the frames (3) a plurality of the light emitting members (4) are disposed.

2. The display device according to claim 1 characterized in that the light emitting members (4) have an elongated shape and are disposed side by side within the regions defined by the frames (3).

3. The display device according to claim 2, characterized in that the light emitting members (4) are disposed perpendicularly to a longitudinal direction of the regions defined by the frames (3).

4. The display device according to claim 3, characterized in that at least three light emitting members (4) are provided.

5. The display device according to one of claims 1 to 4, characterized in that the light emitting members (4) comprise an incandescent lamp (13).

6. The display device according to one of claims 1 to 4, characterized in that the light emitting members (4) comprise a fluorescent lamp (13).

7. The display device according to one of claims 1 to 6, characterized in that the board (2) comprises a printed circuit board, and the surface (2a) opposing the liquid crystal panel (1) is colored white.

## Patentansprüche

1. Flüssigkristall-Anzeigevorrichtung mit einem Flüssigkristallfeld (1), das wenigstens zwei räumlich getrennte, jeweils verschiedene Information anzeigende-Anzeigeblöcke (1a) aufweist;

einer auf der Rückseite des Flüssigkristallfeldes (1) angeordneten Platte (2); und

einer Mehrzahl von lichtemittierenden Teilen (4), die in gleichem gegenseitigen Abstand auf der Platte (2) über den gesamten Bereich des Flüssigkristallfeldes (1) angeordnet sind, dadurch gekennzeichnet, daß

zwischen der Rückseite des Flüssigkristallfeldes (1) und den lichtemittierenden Teilen (4) eine Diffusionsplatte (5) angeordnet ist;

die Anzeigevorrichtung ferner einen um jeden der Anzeigeblöcke (1a) des Flüssigkristallfeldes (1) angeordneten Rahmen (3) aufweist, wobei die Rahmen (3) reflektierende Wände (3a) besitzen und zwischen der Diffusionsplatte (5) und der Platte (2) angeordnet sind; und

im durch die Rahmen (3) definierten Bereich eine Mehrzahl von lichtemittierenden Teilen (4) angeordnet ist.

2. Anzeigevorrichturg gemäß Anspruch 1, dadurch gekennzeichnet, daß die lichtemittierenden Teile (4) eine längliche Form besitzen und in den durch die Rahmen (3) definierten Bereichen Seite an Seite angeordnet sind.

3. Anzeigevorrichtung gemäß Anspruch 2, dadurch gekennzeichnet, daß die lichtemittierenden Teile (4) senkrecht zu einer Längsrichtung der durch die Rahmen (3) definierten Bereiche angeordnet sind.

4. Anzeigevorrichtung gemäß Anspruch 3, dadurch gekennzeichnet, daß wenigstens drei lichtemittierende Teile (4) vorgesehen sind.

5. Anzeigevorrichtung gemäß einem der Ansprüche 1 bis 4, dadurch gekennzeichnet, daß die lichtemittierenden Teile (4) eine Glühlampe (13) aufweisen.

6. Anzeigevorrichtung gemäß einem der Ansprüche 1 bis 4, dadurch gekennzeichnet, daß die lichtemittierenden Teile (4) eine Leuchtstofflampe (13) aufweisen.

7. Anzeigevorrichtung gemäß einem der Ansprüche 1 bis 6, dadurch gekennzeichnet, daß die Platte (2) eine gedruckte Leiterplatte aufweist und die dem Flüssigkristallfeld (1) gegenüberliegende Fläche (2a) weiß eingefärbt ist.

**Revendications**

1. Dispositif d'affichage comportant un panneau à cristaux liquides comprenant

un panneau à cristaux liquides (1) comportant au moins deux blocs d'affichage (1a) spatialement séparés chacun pour afficher un type différent d'informations;

un panneau (2) disposé en face de la face postérieure du panneau à cristaux liquides (1), et

une pluralité d'éléments émetteurs de lumière (4) disposés uniformément'espacés les uns des autres sur le panneau (2) sur toute la région du panneau à cristaux liquides (1),

caractérisé en ce qu'une plaque de diffusion (5) est disposée entre la face postérieure du panneau à cristaux liquides (1) et les éléments émetteurs de lumière (4),

le dispositif d'affichage comporte en outre un cadre (3) autour de chacun des blocs d'affichage (1a) du panneau à cristaux liquides (1), les cadres (3) possédant des parois réfléchissantes (3a) et étant disposés entre la plaque de diffusion (5) et le panneau (2), et

à l'intérieur de chaque région définie par les cadres (3) est disposée une pluralité d'éléments émetteurs de lumière (4).

2. Dispositif d'affichage selon la revendication 1, caractérisé en ce que les éléments émetteurs de lumière (4) possèdent une forme allongée et sont disposés côte à côte à l'intérieur des régions définies par les cadres (3).

3. Dispositif d'affichage selon la revendication 2, caractérisé en ce que les éléments émetteurs de lumière (4) sont disposés perpendiculairement à une direction longitudinale des régions définies par les cadres (3).

4. Dispositif d'affichage selon la revendication 3, caractérisé en ce qu'au moins trois éléments émetteurs de lumière (4) sont prévus.

5. Dispositif d'affichage selon une quelconque des revendications 1 à 4, caractérisé en ce que les éléments émetteurs de lumière (4) comportent une lampe à incandescence (13).

6. Dispositif d'affichage selon une quelconque des revendications 1 à 4, caractérisé en ce que les éléments émetteurs de lumière (4) comportent une lampe flurorescente (13).

7. Dispositif d'affichage selon une quelcon que des revendications 1 à 6, caractérisé en ce que le panneau (2) comporte une plaque de circuit imprimé, et la surface (2a) en face du panneau à cristaux liquides (1) est blanche.

FIG.1

FIG.2

# FIG.3